# EUROPÄISCHE PATENTANMELDUNG

(11) **EP 1 624 736 A2**
(43) Veröffentlichungstag der Anmeldung: **08.02.2006**
(21) Anmeldenummer: 05106647.0
(22) Anmeldetag: 20.07.2005
(51) Int. Cl.: H05K 1/14

(54) **Verfahren zur Herstellung einer elektrisch leitenden Verbindung bei einer T-förmigen oder L-förmigen Leiterplattenkonfiguration**

(30) Priorität: 04.08.2004 DE 102004038305
(71) Anmelder: SIEMENS AKTIENGESELLSCHAFT, 80333 München (DE)
(72) Erfinder: Eßmann, Klaus, 38530, Didderse (DE); Gelbhaar, Ulrich, 38122, Braunschweig (DE); Hentschel, Matthias, 38120, Braunschweig (DE)

(57) **Zusammenfassung**

Die Erfindung betrifft ein Verfahren zur Herstellung einer elektrisch leitenden Verbindung bei T-förmigen oder L-förmigen Leiterplattenkonfiguration mit mindestens zwei rechtwinklig aufeinander stehenden Leiterplatten (4, 5). Eine hohe Packungsdichte elektronischer Bauelemente auf den Leiterplatten (4, 5) wird dadurch erreicht, dass in dem Winkelbereich zwischen den beiden Leiterplatten (4, 5) MELF (Metal Electro-de Face)-Connectoren (1) eingelötet werden, deren Metallkappen (3) jeweils mittels winkelförmig angeordneter Lötpads (6) beide Leiterplatten (4, 5) kontaktieren.

## Beschreibung

Die Erfindung betrifft ein Verfahren zur Herstellung einer elektrisch leitenden Verbindung bei einer T-förmigen oder L-förmigen Leiterplattenkonfiguration mit mindestens zwei rechtwinklig aufeinander stehenden Leiterplatten.

Der Trend zu immer kleineren und bedienerfreundlicheren Geräten verlangt wesentlich höhere Bauteildichten auf den Leiterplatten. SMD (Surface Mounted Divices = oberflächenmontierbare Bauelemente) ohne bzw. mit verkürzten Anschlussdrähten und miniaturisierter Bauform entsprechen diesen Anforderungen. Im Gegensatz zu Bauteilen mit Drahtanschlüssen, die meist in durchkontaktierte Löcher der Leiterplatte montiert und gelötet werden, erfolgt die Montage der SMDs nur auf der Oberfläche der Leiterplatte. Die Verbindungsstelle dient dabei gleichzeitig der mechanischen und der elektrischen Verbindung. Die Möglichkeit, beide Seiten der Leiterplatte mit SMDs zu bestücken, trägt ebenfalls zur Verkleinerung der elektronischen Baugruppen bei. Um noch mehr elektronische Bauelemente auf kleinstem Raum unterzubringen, werden Leiterplatten zunehmend in kammförmigen oder gitterförmigen Konfigurationen angeordnet. Dabei muss die Verbindung der rechtwinklig aufeinander stehenden Leiterplatten mechanisch stabil sein und die Anordnung vieler quasi rechtwinkliger elektrischer Verbindungen zwischen den Leiterplatten bei minimalem Platzverbrauch gestatten.

Bisher wurde häufig das Prinzip der Steckverbindungen angewandt. Diese Verbindungsart ist jedoch relativ platzaufwändig.

Ein anderes bekanntes Verfahren besteht in der Verwendung von Lead-Frames. Dabei handelt es sich um kleinste vielpolige Leiter- und Trägerelemente, die beispielsweise L-förmig umbiegbar sind. Nachteilig ist, dass für dieses Fertigungsverfahren Spezialmaschinen erforderlich sind. Außerdem wird der zur Verfügung stehende Platz nicht optimal ausgenutzt. Die Bestückung mit Bauelementen ist nur einseitig möglich.

Der Erfindung liegt die Aufgabe zugrunde, ein gattungsgemäßes Verfahren zur Herstellung einer elektrisch leitenden Verbindung bei einer T-förmigen oder L-förmigen Leiterplattenkonfiguration anzugeben, das sich durch minimalen Platzverbrauch bei vielen Verbindungen der Leiterplatten untereinander, welche für sehr hohe Strombelastung geeignet sind, auszeichnet, wobei weder Spezialmaschinen noch Spezialbauteile erforderlich sein sollen.

Erfindungsgemäß wird die Aufgabe durch die kennzeichnenden Merkmale des Anspruchs 1 gelöst. Der elektrische Übergang von der waagerechten zur senkrechten Leiterplatte wird durch zweckentfremdete MELF (Metal Electrode Face)- Widerstände in der Lötstelle sowohl mechanisch stabilisiert als auch elektrisch optimiert. Der für diese elektrisch leitende Verbindung eingesetzte MELF-Widerstand wird zweckentfremdet eingesetzt. Seiner Bestimmung nach hat der MELF-Widerstand zwischen seinen Metallkappen einen eingeprägten elektrischen Widerstand (in Ω). Für diese Anwendung ist nur der Keramikkörper ohne eingeprägten Widerstand vorgesehen. Somit ist der Widerstand unendlich und der Keramikkörper wird nur als Träger für die Metallkappen genutzt. Daher wird im Folgenden dieses Bauelement als MELF-Connector bezeichnet. Der Keramikkörper der MELF-Connectoren dient als Trägermaterial für die Metallkappen und zur mechanischen Stabilisierung der Lötkontakte. Die Metallkappen der MELF-Connectoren kontaktieren mittels winkelförmig angeordneter Lotpads beide Leiterplatten. Die Metallkappen fungieren quasi als elektrische Verbinder zwischen den Leiterplatten. MELF-Connectoren sind sehr klein, kostengünstig, erfordern keine Durchkontaktierungen in der Leiterplatte und sind auch für Ströme von mehreren Ampere geeignet. So genannte Mikro-MELF beispielsweise sind normgemäß nur 2,2mm lang bei einem Durchmesser von 1,1mm. Dieser geringe Platzbedarf auf den Leiterplatten ermöglicht eine verbesserte Leiterplattenausnutzung.

Gemäß Anspruch 2 werden die Metallkappen der MELF-Coonection in die mit Lotpaste bedruckten Lötpads gesetzt. Die MELF-Connectoren schwimmen nach dem Reflowlöten so ein, dass sie vor dem zweiten Löten, dem Verbindungslöten, in der Lotpaste der Leiterplatte ruhen. Dieses ist durch eine entsprechende Layoutgestaltung zu sichern. Ein Kleben ist nicht notwendig.

Die Bestückung und das Einlöten kann gemäß Anspruch 3 mit konventionellen Bestückungs- und Lötanlagen mit Standard-Lotpaste erfolgen. Spezialmaschinen sind nicht erforderlich. Vorzugsweise werden die so genannten Massenlötverfahren angewendet, bei denen die Lötverbindungen simultan hergestellt werden. Auch das Bestücken mit den MELF-Connectoren und den restlichen Bauteilen der Leiterplatten kann mittels konventioneller Verfahren zeitgleich erfolgen.

Prinzipiell kann das Bestücken manuell, mit mechanisierten Bestückhilfen oder mit Bestückungsautomaten erfolgen. Je nach der Stückzahl der zu fertigenden Baugruppen, der Anzahl der unterschiedlichen Typen und der Losgröße wird eines dieser Verfahren angewendet. Gemäß Anspruch 4 ist die Bestückung und Verlötung vorzugsweise mittels als Universalmaschine ausgebildeter Bestückungslinie vorgesehen. Die Bestückungslinie führt den Lotpastendruck, die Bestückung und das Reflowlöten durch, wobei im Durchschnitt Bestückleistungen zwischen 500 und 2000 Bauteilen pro Stunde erzielt werden. Da handelsübliche MELF-Connectoren auf einer Rolle geliefert werden, sind diese bereits für den Bestückungsautomaten vorbereitet.

Nachfolgend wird die Erfindung anhand figürlicher Darstellungen näher erläutert. Es zeigen:
- Figur 1: den prinzipiellen Aufbau eines MELF-Connectors,
- Figur 2: die Verwendung von MELF-Connectoren für die Verbindung zweier Leiterplatten und
- Figur 3: eine Seitenansicht der Leiterplattenverbindung gemäß Figur 2.

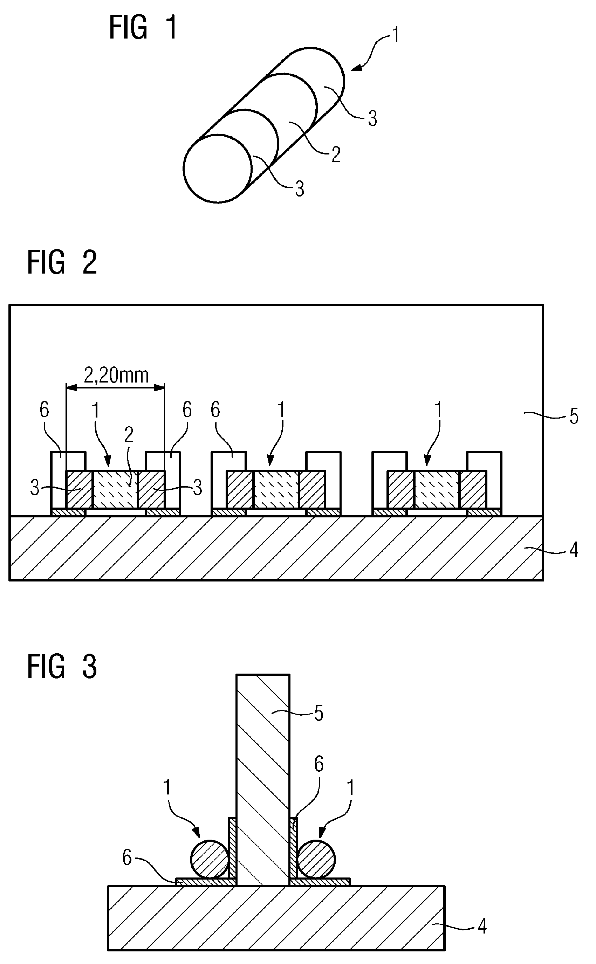

Ein in Figur 1 dargestellter MELF-Connector 1 besteht im Wesentlichen aus einem zylindrischen Keramikkörper 2 mit zwei Polen in Form von Metallkappen 3.

Die Figuren 2 und 3 veranschaulichen die Verwendung derartiger MELF-Connectoren 1 zur Herstellung einer T-förmigen Leiterplattenverbindung. Dazu werden in den Winkelbereichen einseitig oder beidseitig der rechtwinklig auf einer ersten Leiterplatte 4 stehenden zweiten Leiterplatte 5 in Abständen Lötpads 6 vorgesehen. Die Abstände sind dabei derart an die Größe der MELF-Connectoren 1 angepasst, dass deren Metallkappen 3 über die Lötpads 6 und Lötstellen beide Leiterplatten 4 und 5 ausreichend kontaktieren. Da MELF-Connectoren sehr klein sind, beispielsweise eine Länge von nur 2,20mm aufweisen, können die Kontaktstellen zur elektrischen Verbindung zwischen den beiden Leiterplatten 4 und 5 sehr dicht nebeneinander angeordnet werden. Dazu trägt auch die 100-%ige Isolationswirkung durch die Keramikkörper 2 der MELF-Connectoren 1 bei. Auf diese Weise ergibt sich die Möglichkeit, eine sehr hohe Packungsdichte der elektronischen Bauelemente auf den Leiterplatten 4 und 5 zu erreichen.

Die Erfindung beschränkt sich nicht auf das vorstehend angegebene Ausführungsbeispiel. Vielmehr ist eine Anzahl von Varianten denkbar, welche auch bei grundsätzlich anders gearteter Ausführung von den Merkmalen der Erfindung Gebrauch machen.

## Patentansprüche

1. Verfahren zur Herstellung einer elektrisch leitenden Verbindung bei einer T-förmigen oder L-förmigen Leiterplattenkonfiguration mit mindestens zwei rechtwinklig aufeinander stehenden Leiterplatten (4, 5),
**dadurch gekennzeichnet,**
**dass** in den Winkelbereich zwischen den beiden Leiterplatten (4, 5) MELF (Metal Electrode Face)-Connectoren (1) eingelötet werden, deren Metallkappen (3) jeweils mittels winkelförmig angeordneter Lötpads (6) beide Leiterplatten (4, 5) kontaktieren.

2. Verfahren nach Anspruch 1,
**dadurch gekennzeichnet,**
**dass** die zylindrischen Keramikkörper (2) der MELF-Connectoren (1) mit ihren Metallkappen (3) in die mit Lotpaste bedruckten Lötpads (6) der Leiterplatte (4, 5) gesetzt werden.

3. Verfahren nach einem der vorangehenden Ansprüche,
**dadurch gekennzeichnet,**
**dass** die Bestückung und das Einlöten mit konventionellen Bestückungs- und Lötanlagen mit Standard-Lotpaste erfolgt.

4. Verfahren nach einem der vorangehenden Ansprüche,
**dadurch gekennzeichnet,**
**dass** die Bestückung und das Löten mit konventionellen, als Universalmaschinen ausgebildeten Bestückungslinien erfolgt.
